# EUROPEAN PATENT SPECIFICATION

(11) **EP 1 217 879 B1**
(45) Date of publication and mention of the grant of the patent: **28.10.2009**
(21) Application number: 01129577.1
(22) Date of filing: 12.12.2001
(51) Int. Cl.: H05K 7/20

(54) **Method and equippment for the thermal conditioning of cabinets containing electronic assemblies**
Verfahren und Einrichtung zur thermischen Konditionierung von elektronische augruppen enthaltenden Schränken
Méthode et équipement pour le conditionnement thermique d' armoires contenant des composants électroniques

(30) Priority: 22.12.2000 IT MI002799
(43) Date of publication of application: 26.06.2002
(73) Proprietor: Nokia Siemens Networks GmbH & Co. KG, 81541 München (DE)
(72) Inventor: Frigerio, Giuseppe, 20085 Locate Triulzi (IT); Polli, Roberto, 20066 Melzo (IT); Santambrogio, Corrado, 20030 Seveso (IT)

(56) References cited:
- DE-B- 1 233 560
- GB-A- 2 202 681
- US-A- 4 495 545
- US-A- 4 735 258
- US-A- 6 142 866

## Description

### Field of the invention

The present invention relates to the cabinets for electronic assemblies, in particular for telecommunication, and more in particular, object of the same is a method and equipment for the thermal conditioning of said cabinets.

It is well known that electronic assemblies, in particular those concerning telecommunication plants, shall be kept at temperatures in the range of ***20-25°C*** in order to operate in the correct manner. An important aspect in the assembly design is therefore the dissipation of heat developed by them. To this purpose, the different parts of the equipment are installed on supports or in containers assuring high heat dissipation. The cabinets destined to contain the complete equipment are then associated to thermal conditioning means.

### Background art

Two solutions are generally known for said thermal conditioning.

A first solution employs active (or closed circuit) air conditioning systems, whichever the outside temperature is: in the latter, air coming from the cabinets is cooled, and so cooled, it is reintroduced in the cabinets. Examples of these systems are disclosed in JP-A-11083354 and JP-A-11135972. Being these systems always in operation, they show high power consumption. Moreover, they originate temperature short-term fluctuations, tied to the transient of the thermal cycle, which reduce the average time between failures. This is an important aspect for assemblies, such as base stations of mobile communication systems placed in areas comparatively difficult to reach by maintenance operators or anyway far from maintenance centres.

The second solution employs a free ventilation cooling (known as "free cooling"), according to which air drawn from the external environment is let into the cabinet, and hot air coming from the cabinet is exhausted to the outside. An example is disclosed in WO-A-9414308. Free ventilation cooling systems are intrinsically free from short-term fluctuations, however, they are scarcely effective or unusable where there is not a sufficient differential between the outside temperature and the internal one.

The other solutions are known from US-A-4 735 258 and GB-A-2 202 681.

### Object and summary of the invention

Scope of the invention is to give an air-conditioning method and equipment effective in any climatic condition, enabling a reduced power consumption and minimizing the temperature short-term fluctuations.

The method according to the invention includes the following steps:
- detecting the temperature of outside air;
- comparing the outside temperature with an upper and lower temperature threshold;
- if the temperature exceeds the upper threshold, operating in closed circuit, sending the assemblies cold air obtained through mechanical cooling of hot air drawn from the cabinet;
- if the temperature is under the lower threshold, keeping the mechanical cooling means disabled and operate in open circuit, sending air drawn from the external environment to the assemblies and running hot air drawn from the cabinet into the environment again;
- if the outside temperature is in a band included between the upper and lower thresholds, enabling the mechanical cooling means and send the assemblies a cold air flow obtained by cooling a mix including both air coming from the cabinet and external air, in proportions depending on the values of outside and internal temperature.

The equipment according to the invention includes:
- a first and a second air inlet, for the introduction in the equipment of air coming from the cabinet and of outside air, respectively;
- a first and a second air outlet, to send cooling air to the assemblies and to exhaust air to the environment, respectively;
- mechanical cooling means of air inlet in the equipment;
- a logic control unit for detecting the temperature of air outside the cabinet, comparing it with a temperature upper and lower threshold, enabling mechanical cooling means if the temperature is not lower than the lower threshold, and, based on the outside temperature, controlling the equipment operation according to one of the following three conditions: a) closed circuit mechanical cooling, in which air coming from the cabinet is cooled with said cooling means and sent to the assemblies, if the temperature exceeds the upper threshold; b) free ventilation cooling, in which air drawn from the outside environment is sent to the assemblies, at ambient temperature, and air drawn from the cabinet is exhausted to the atmosphere, if the outside temperature is under the relevant lower threshold; c) mixed cooling, in which a mix of air coming from the cabinet and of outside is cooled with con said cooling means and sent to the assemblies, in relative proportions depending on the outside and internal temperature, if the outside temperature is in a band delimited by the thresholds.

Profitably, the equipment is housed in a construction module built-in the cabinet to cool.

### Brief description of drawings

Further characteristics of the present invention considered to be novel are set forth with particularity in the appended claims.

The present invention together with further objects and advantages thereof may be understood with reference to the following detailed description, taken in conjunction with the accompanying drawings, in which:
- Figure 1 is a front view of a cabinet for electronic assemblies, employing the air conditioning system scope of the invention;
- Figure 2 is a prospect view of cabinet module containing the air-conditioning equipment of the invention,
- Figure 3 is a schematic cross-section view of the module of Figure 2;
- Figures 4A - 4C are schematic views showing three different operation conditions of the equipment;
- Figure 5 is a flow chart of the method; and
- Figure 6 is a diagram of some phases of the mixed cooling.

### Description of an embodiment of the invention

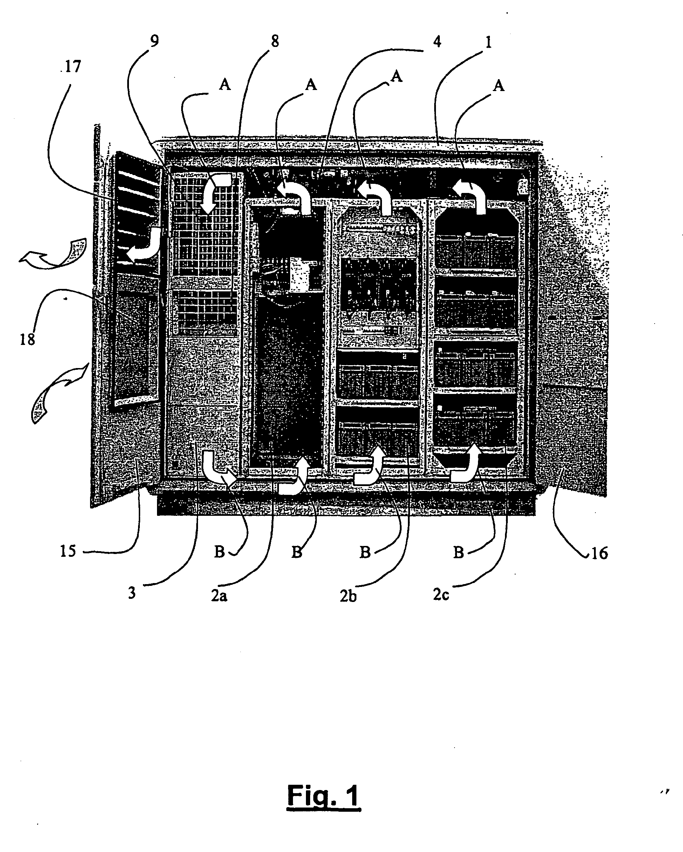

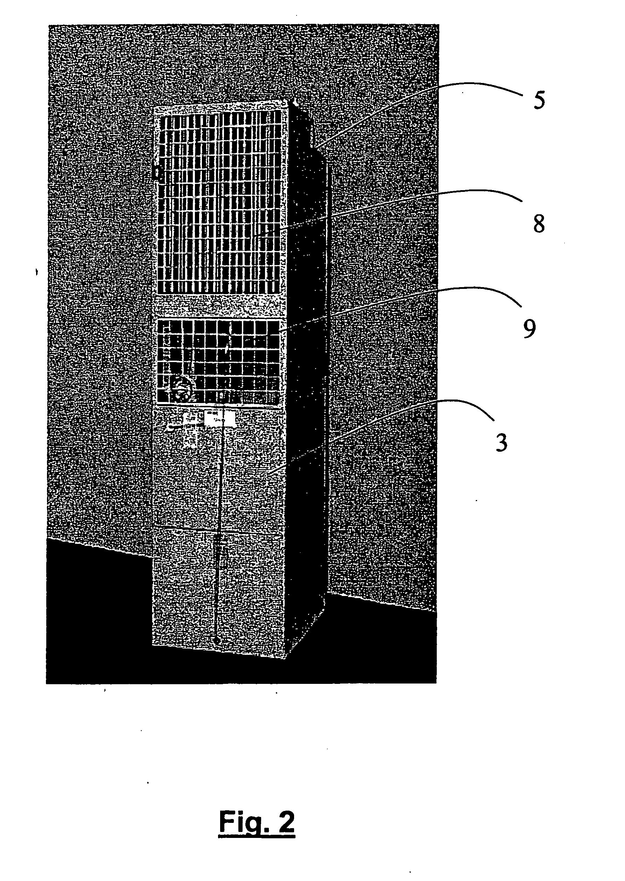

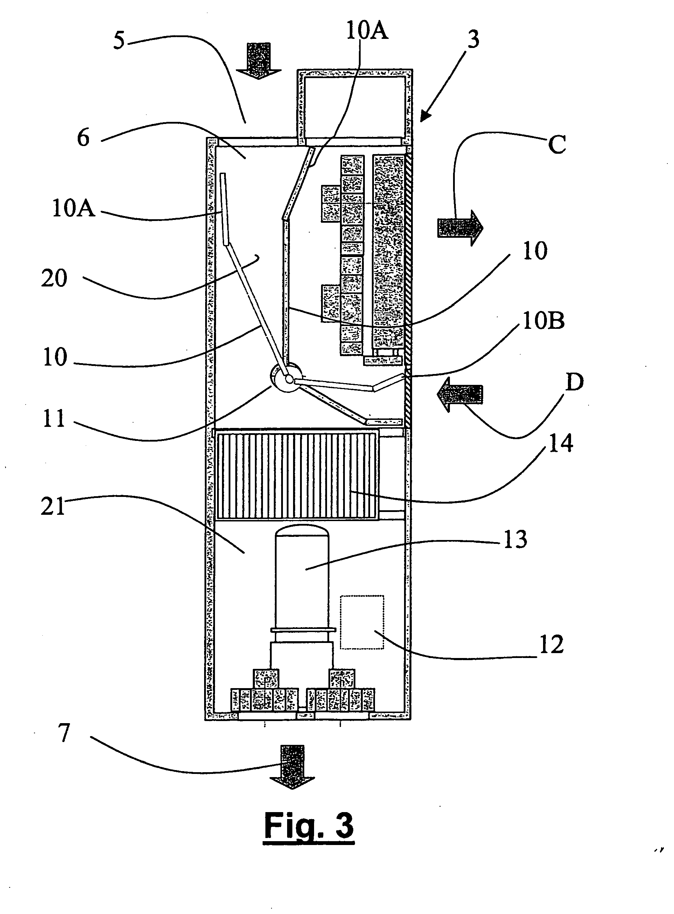

With reference to Figures 1 - 3, a cabinet 1 including a given number of modules (three in the example shown in the in figure 2a, 2b, 2c) for electronic assemblies and their power supply devices, and an additional module 3 housing the air conditioning system of the invention. Modules 2a - 2c are open at top, to enable the exit of hot air to send to module 3, and at bottom for the inlet of cold air coming from module 3, as indicated by arrows A, B. The modules 2a - 2c have height such to define, with the ceiling of cabinet 1, a hollow space 4 to convey hot air to module 3, which in turn shows a rear lowered upper part, as it could be seen in detail in Figures 2 and 3 where this lowered portion has been denoted with the numeric reference 5.

On this lowered portion, an inlet opening 6 is made for hot air conveyed by channel 4. On the contrary, a lower opening 7 enables to send cold air toward modules 2a-2c, through a hollow space similar to hollow space 4, not shown in the drawings.

The module 3 houses a system capable of operating both in closed circuit and free ventilation mode. According to the invention, the two types of cooling can be separately and jointly actuated, according to the temperature conditions existing inside and outside the cabinet 1. In particular, three outside temperature bands are identified:
- a high band, in which the closed circuit cooling only is used ;
- a low band, in the free ventilation cooling only is used, and
- an intermediate band, in which both are used.

The front wall of module 3 shows two superimposed openings 8, 9 closed with relevant grates, used for the exhaust of hot air to the environment (arrow C) and for the inlet of air sucked from the external environment (arrow D), respectively, during the free ventilation cooling.

Inside module 3, the upper part placed behind the grates 8, 9 forms an air handling section or chamber 20, and houses a gate 10, with a vertical section, L or obtuse angle shaped, which defines air paths requested by the cooling methods adopted on that moment. The position of gate 10 is represented in grey in the figure for the case of sole closed circuit cooling operating, while the position is white coloured when the sole free ventilation cooling is operating. The gate 10 is operated by a servomotor 11 controlled by a logic control unit 12 installed in the lower part of the module 3. The unit 12 is associated to appropriate sensors, not represented, both of the temperature outside and inside the cabinet, and of the relative humidity of external air, in order to decide the more appropriate cooling method in respect with particular climatic conditions. When the closed circuit cooling and the free ventilation one jointly operate, the logic unit can make the gate 10 assume any intermediate position among those shown in fig. 3. Devices like unit 12 are well known in the sector of air-conditioning plants.

The lower internal part of module 3 forms an evaporation section or chamber 21 and houses the compressor 13 of the mechanical cooling system and a dripping pan 14 for condensate water.

The cabinet 1 shows also (see figure 1) closure doors, 16, and the door 15 shall in turn be equipped with slots 17, 18 for air passage, matching openings 8, 9. These openings are fit with relevant filters: the opening 18 is equipped with filter to hold air impurities, while opening 17 is fit with attenuation system for the noise cause by air exhaust.

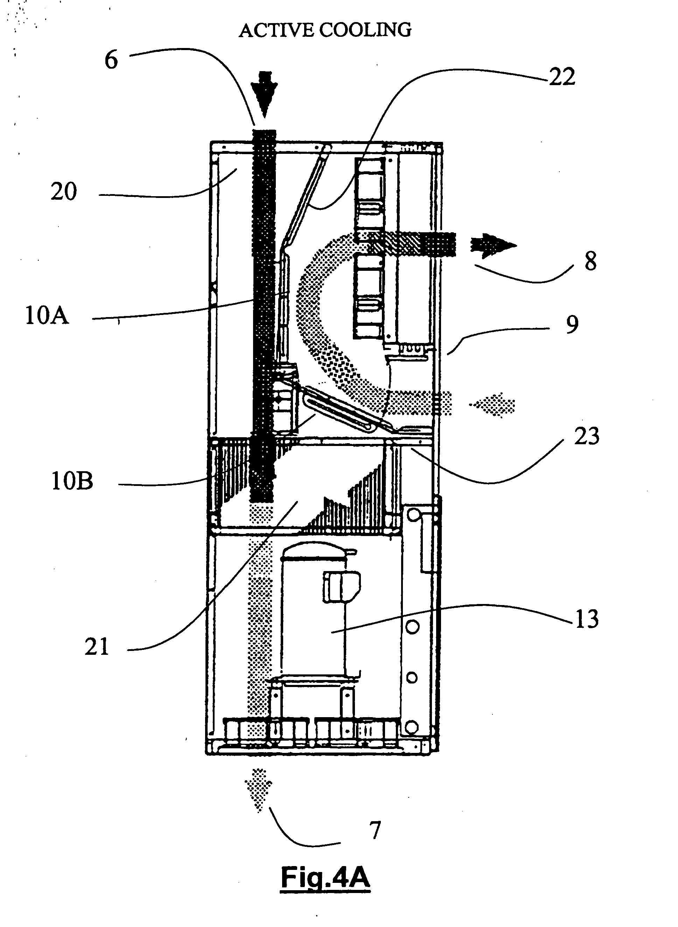

Figures 4A - 4C show more in detail the air flows corresponding to the use of the sole closed circuit cooling, of the sole free ventilation cooling and of the mixed cooling. In these figures, black arrows indicate hot air and white arrows cold air.

In the mechanical cooling condition or ACTIVE COOLING (Figure 4A), the upper arm 10A of gate 10 rests against a partition 22 projecting downward from the module ceiling, while the other arm 10B rests against a partition 23 foreseen matching the separation area between chambers 20, 21. In these conditions the gate 10 defines a passage carrying hot air entering the upper opening 6 towards the evaporation chamber 21 (where it is cooled, since the compressor 13 is operating) and from there, to the lower opening 7, while it prevents the passage of air itself towards opening 9 and the exhaust to the environment through this one.Possible external air entering opening 9 is diverted through opening 8 and re-inlet in the environment, without participating in the cooling process.

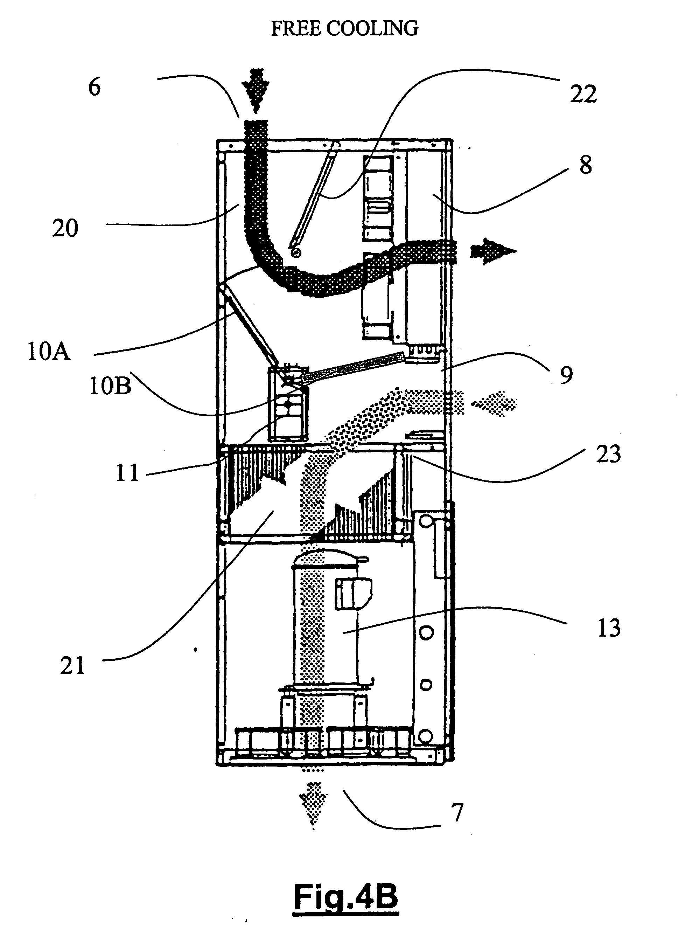

In the free ventilation cooling condition or FREE COOLING (Fig. 4B) the compressor 13 is not operating and the gate 10 is rotated in order that the free end of the arm 10A rests against the rear wall of the module 3 and the free end of the arm 10B is placed matching the lower part of opening 8.In these conditions the gate 10 defines a passage carrying hot air entering the upper opening 6 towards opening 8, for dispersion to the atmosphere, while external air entering through the opening 9 is deviated towards the chamber 21 and the lower opening 7.

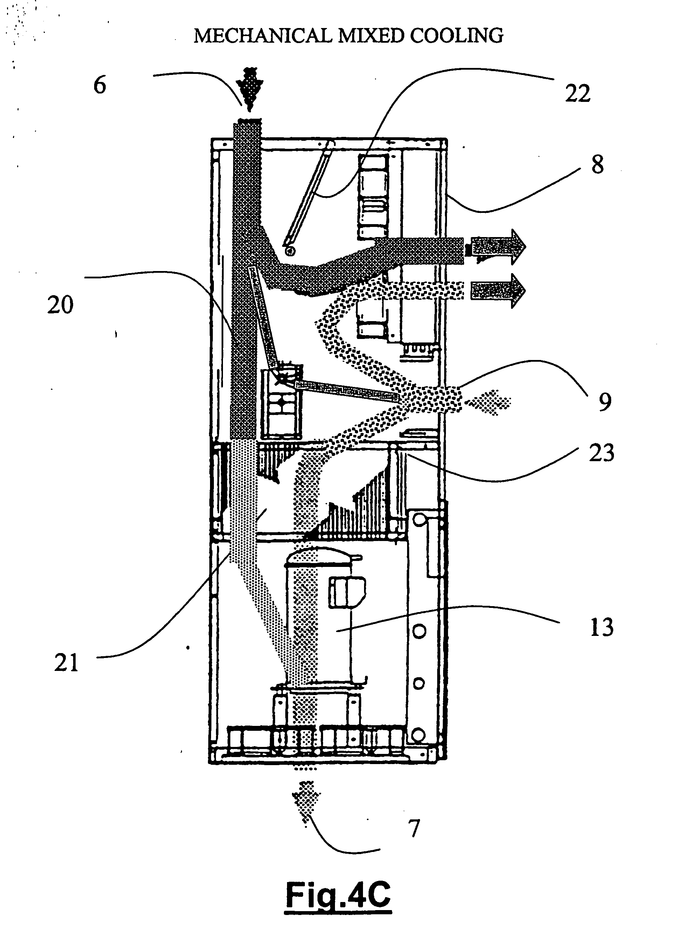

Finally, in the mixed cooling condition or MECHANICAL MIXED COOLING (Fig. 4C) condition, the gate is at an intermediate position between those of figures 4A and 4B, enabling the passage to the evaporation section 21 both of air coming from the cabinet through opening 6, and of external air entering opening 9. The compressor 13 is operating and therefore also external air is cooled. The relevant proportions of the two air inlets will depend on the particular position of the gate, determined by the logic unit 14. This position shall be selected according to the temperature difference between internal and external air, and it could be modified by discrete steps or even continuously, as this difference varies.

During the operation conditions corresponding to figures 4B, 4C a check of the relative humidity of external air shall also be made, to switch to operation in closed circuit in case of exceptional climatic conditions.

Through an opportune selection of actuation thresholds, it is possible to apply the operation condition, corresponding to the intermediate band, for the major part of the operating time of the air-conditioned system during the year. For instance, considering that typically, the temperature values of the assemblies must be included between -20 and +50 °C, the upper threshold could be included for instance between 30°C and 50°C, and the lower temperature threshold between 10°C and 25°C. During the operation in the intermediate band, there could be a variation in the gate position and if the difference between the internal and external temperature varies more than a threshold selected for instance between 2°C and 3°C.

The humidity threshold causing to pass to the closed circuit cooling could be included for instance between 40% and 80%.

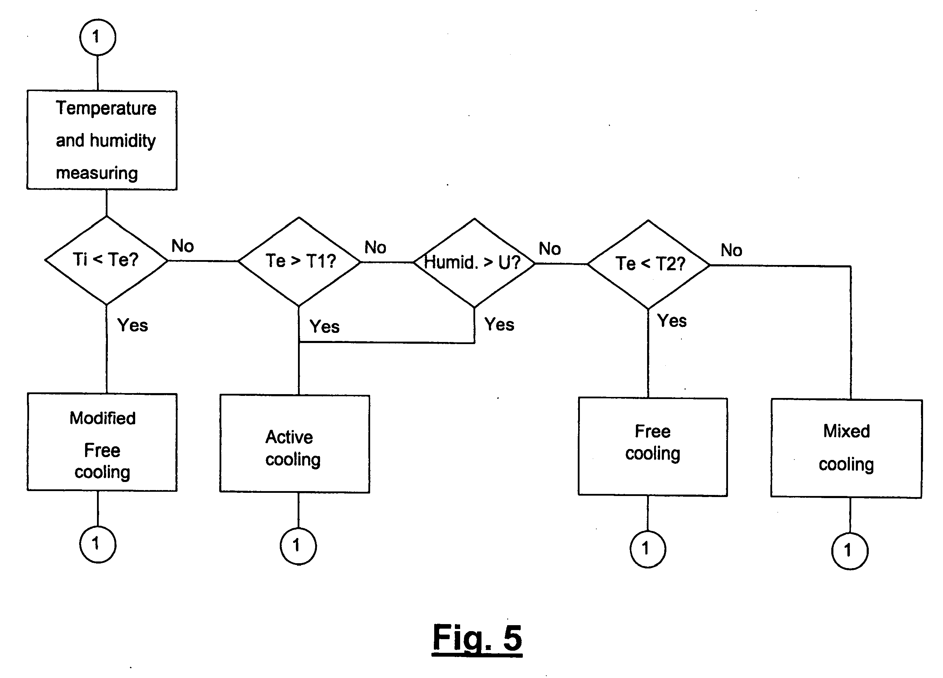

Figure 5 shows as a flow chart, the procedure of the invention. In this diagram Te indicates the external air temperature, T1 and T2 indicate the temperature upper and lower threshold, respectively and U the relative humidity threshold. The cycle shown is repeated at pre-determined intervals. Considering the previous description the diagram is clear and does not require any additional explanation.

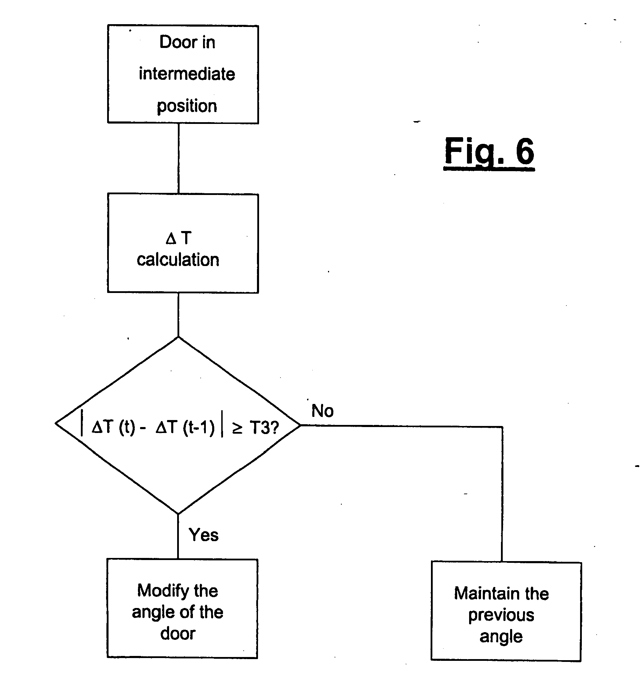

Figure 6 shows on the contrary the checks on the external and internal temperature made during the mixed cooling operation. In particular, we have indicated that if the difference ΔT between the two temperatures, between two subsequent monitoring instants t-1 and t, varies of a quantity higher than a given threshold T3, the angle of gate 10 is changed, in order to vary the proportions of external and internal air.

The essential advantage of the invention is that the free ventilation operation is expanded also to temperatures that otherwise could not employ it, and there is a reduction of the number of thermal cycles in the time unit. This reduces the oscillations compared to the closed circuit operation, in which it is employed the thermal capacity of the equipment to stabilise the control of the air conditioning system: being the operation of the system of the on/off type, this generates an expensive thermal cycle for electronics, mainly in compact solutions as the one described, where the air conditioner outlet is directly connected to the inlet of the equipment. Furthermore, it is obtained a considerable electric power saving, compared to the use of a close circuit air conditioning.

It is evident that what disclosed is given only as a non-limiting example and that other embodiments and modifications are possible without departing from the scope of the invention.
For instance, it is possible to include an additional step foreseeing also the measurement of internal temperature Ti and then make a comparison between the outside temperature Te at the cabinet and the internal temperature Ti as shown in Figure 5. If this comparison highlights that the internal temperature is equal to or higher than the outside temperature, the operation cycle already described is restarted.
If on the contrary, the comparison highlights that the internal temperature is under the above mentioned lower threshold, for instance because the cabinet is equipped with a limited number of assemblies, mechanical cooling means are kept disabled and operation takes place in closed circuit, sending the assemblies air drawn from the internal environment. In other words we operate according to a sort of "close circuit cooling" during which non-cooled air drawn from the internal environment is sent to the assemblies instead of air drawn from the external environment as it occurs in the traditional "free cooling".

## Claims

1. Method for the thermal conditioning of a cabinet containing electronic assemblies, including the following steps:
I. detecting the temperature of air outside the cabinet;
II. comparing the outside temperature with an upper and lower temperature threshold
III. if the temperature exceeds the upper threshold, operating in closed circuit, sending cold air obtained from mechanical cooling by mechanical cooling means of not air drawn from the cabinet to the assemblies;
IV. if the temperature is under the lower threshold, keeping the mechanical cooling means disabled and operate in open circuit, sending the assemblies air drawn from the external environment and exhausting to the atmosphere hot air drawn from the cabinet;
V. if the outside temperature is in a range included between the upper and lower thresholds, sending a cold air flow obtained through mechanical cooling of a mix including both air coming from the cabinet and external air to the assemblies, in proportions depending on the values of the outside and internal temperature

2. Method according to claim 1, **characterized in that** it foresees also the following steps:
- detecting the temperature of air inside the cabinet;
- comparing the result of the detection of the outside temperature with the result of the internal temperature one;
- if the above mentioned comparison highlights that the internal temperature is equal to or higher than the outside temperature, restart the steps cycle from I.) to V.), while,
- if the above mentioned comparison highlights that the internal temperature is under the above mentioned lower threshold, keeping the mechanical cooling means disabled and operate in closed circuit, sending air drawn from the internal environment to the assemblies.

3. Method according to claim 1, **characterized in that** said upper temperature threshold is included between 30°C and 50°C, and the lower temperature threshold is included between 10°C and 25°C.

4. Method according to claims 1 and 3, **characterized in that**, in the temperature intermediate range, the relative proportions of air coming from the cabinets and of the outside air are modified when there is a variation of the relative temperature included between 2°C and 3°C.

5. Method according to any claim 1 to 4, **characterized in that**, during the steps in which outside air is sent to the assemblies, the relative humidity of outside air is monitored and if it exceeds a limit value, the operation is switched to closed circuit.

6. Method according to claim 5, **characterized in that** said limit value is included between 40% and 80%.

7. Equipment for the thermal conditioning of a cabinet for electronic assemblies, including:
- a first and a second air inlet (6, 9), to inlet in the equipment air coming from the cabinet (1) and external air, respectively;
- a first and a second air outlet (7, 8), to send cooling air to the assemblies and to re-inlet air in the environment, respectively;
- mechanical cooling means (13) of air inlet in the equipment;
- a logic control unit (12) for detecting the temperature of air outside the cabinet (1), comparing it with an upper and lower temperature threshold, enabling the mechanical cooling means (13) if the temperature is not lower than the lower threshold, and, on the basis of the outside temperature, controlling the operation of the equipment according to one out of three conditions: a) closed circuit mechanical cooling, in which air coming from the cabinet (1) is cooled with said cooling means (13) and sent to the assemblies if the temperature exceeds the upper threshold; b) free ventilation cooling, in which air drawn from the external environment is sent to the assemblies, at ambient temperature and air drawn from the cabinet (1) is re-inlet in the environment, if the outside temperature is under the lower threshold; c) mixed cooling, in which a mix of air coming from the cabinet (1) is cooled air with said cooling means (13) and mixed with external and sent to the assemblies, in relative proportions depending on the outside temperature and on the internal one, if the outside temperature is in a range delimited by the thresholds.

8. Equipment according to claim 7, **characterized in that** it includes air- flow control means (10), controlled by said logic unit (12) and suitable to establish a communication of a), b) and c) in the relevant operation conditions:
a) the first inlet (6) and the first outlet (7), through a chamber (21) having inside operating mechanical cooling means (13);
b) the second inlet (9) with the first outlet (7), through the chamber (21) at which inside the mechanical cooling means (13) are not operating, and the first inlet (6) with the second outlet (8);
c) the first and second inlet (6, 9) with the first outlet (7), through the chamber (21) at which inside mechanical cooling means (13) are operating.

9. Equipment according to claim 7 or 8, **characterized in that** said air control means include a gate (10) that can be rotated by a servomotor (11), following the control of the logic unit (12) in order to assume a first and a second limit switch position, matching operation conditions a) and b), while in the operation condition c) the gate (10) assumes a plurality of intermediate positions, each one corresponding to a different relative proportion of air coming from the cabinets and of external air in the mix.

10. Equipment according to claim 9, **characterized in that** the logic unit is connected to external humidity detection means, and suitable to bring the equipment from the operation condition b) or c) to the a) condition when the relative humidity exceeds a given threshold.

11. Cabinet for electronic assemblies, including a plurality of modules (2A...2C) housing the assemblies, and at least an additional module (3) housing an air conditioning equipment according to any claim 7 through 9.

## Patentansprüche

1. Verfahren für das thermische Konditionieren eines Schranks, der Elektronikbaugruppen enthält, einschließlich der folgenden Schritte:
I. Detektieren der Temperatur der Luft außerhalb des Schranks;
II. Vergleichen der Außentemperatur mit einem oberen und unteren Temperaturschwellwert;
III. wenn die Temperatur den oberen Schwellwert übersteigt, Arbeiten in einem geschlossenem Kreis, Senden von kalter Luft, die erhalten wird aus der mechanischen Kühlung von aus dem Schrank zu den Baugruppen angesaugter heißer Luft durch mechanische Kühlmittel;
IV. wenn die Temperatur unter dem unteren Schwellwert liegt, das mechanische Kühlmittel gesperrt halten und in einem offenen Kreis arbeiten, Senden von von der äußeren Umgebung angesaugter Luft an die Baugruppen und Abgeben von aus dem Schrank angesaugter heißer Luft an die Atmosphäre;
V. wenn die Außentemperatur in einem Bereich liegt, der zwischen dem oberen und unteren Schwellwert enthalten ist, Senden eines Kaltluftstroms, der erhalten wird durch mechanisches Kühlen einer Mischung, die sowohl von dem Schrank kommende Luft als auch externe Luft enthält, zu den Baugruppen in Anteilen, die von den Werten der Außen- und Innentemperatur abhängen.

2. Verfahren nach Anspruch 1, **dadurch gekennzeichnet, daß** es auch die folgenden Schritte vorsieht:
- Detektieren der Temperatur von Luft im Schrank;
- Vergleichen des Ergebnisses der Detektion der Außentemperatur mit dem Ergebnis der Innentemperatur;
- wenn der oben erwähnte Vergleich hervorhebt, daß die interne Temperatur größer oder gleich der Außentemperatur ist, erneutes Starten des Zyklus der Schritte von I.) bis V.), während,
- wenn der oben erwähnte Vergleich hervorhebt, daß die interne Temperatur unter dem oben erwähnten niedrigeren Schwellwert liegt, weiteres Gesperrthalten des mechanischen Kühlmittels und Arbeiten im geschlossenen Kreis, Senden von aus der internen Umgebung angesaugter Luft zu den Baugruppen.

3. Verfahren nach Anspruch 1, **dadurch gekennzeichnet, daß** der obere Temperaturschwellwert zwischen 30°C und 50°C enthalten ist und der untere Temperaturschwellwert zwischen 10°C und 25°C enthalten ist.

4. Verfahren nach Ansprüchen 1 und 3, **dadurch gekennzeichnet, daß** in dem Temperaturzwischenbereich die relativen Anteile von aus den Schränken kommende Luft und der Außenluft modifiziert werden, wenn eine Variation der relativen Temperatur vorliegt, die zwischen 2°C und 3°C enthalten ist.

5. Verfahren nach einem beliebigen Anspruch 1 bis 4, **dadurch gekennzeichnet, daß** während der Schritte, bei denen Außenluft zu den Baugruppen gesendet wird, die relative Feuchtigkeit von Außenluft überwacht wird, und wenn sie einen Grenzwert übersteigt, der Betrieb auf den geschlossenen Kreis umgeschaltet wird.

6. Verfahren nach Anspruch 5, **dadurch gekennzeichnet, daß** der Grenzwert zwischen 40% und 80% enthalten ist.

7. Gerät für das thermische Konditionieren eines Schranks für Elektronikbaugruppen, enthaltend:
- einen ersten und einen zweiten Lufteinlaß (6, 9) zum Hereinlassen von aus dem Schrank (1) kommender Luft bzw. externer Luft in das Gerät;
- einen ersten und einen zweiten Luftauslaß (7, 8) zum Senden von Kühlluft an die Baugruppen bzw. zum Wiederhereinlassen von Luft in die Umgebung;
- mechanische Kühlmittel (13) von in das Gerät hereingelassener Luft;
- eine Logiksteuereinheit (12) zum Detektieren der Temperatur von Luft außerhalb des Schranks (1), sie mit einem oberen und unteren Temperaturschwellwert vergleichen, Freigeben des mechanischen Kühlmittels (13), wenn die Temperatur nicht unter dem unteren Schwellwert liegt und auf der Basis der Außentemperatur das Steuern des Betriebs des Geräts gemäß einer von drei Bedingungen: a) mechanisches Kühlen im geschlossenen Kreis, bei dem von dem Schrank (1) kommende Luft mit dem Kühlmittel (13) gekühlt und zu den Baugruppen gesendet wird, wenn die Temperatur den oberen Schwellwert übersteigt; b) Kühlung durch freie Lüftung, bei der aus der externen Umgebung angesaugte Luft zu den Baugruppen bei Umgebungstemperatur gesendet wird und von dem Schrank (1) angesaugte Luft wieder in die Umgebung eingelassen wird, wenn die Außentemperatur unter dem unteren Schwellwert liegt; c) gemischte Kühlung, bei der eine Mischung aus aus dem Schrank (1) kommender Luft gekühlte Luft mit dem Kühlmittel (13) und mit außen gemisch wird und zu den Baugruppen gesendet wird in relativen Anteilen in Abhängigkeit von der Außentemperatur und von der Innentemperatur, wenn die Außentemperatur in einem durch die Schwellwerte begrenzten Bereich liegt.

8. Gerät nach Anspruch 7, **dadurch gekennzeichnet, daß** es Luftströmungssteuermittel (10) enthält, die von der Logikeinheit (12) gesteuert werden und sich dafür eignen, eine Kommunikation von a), b) und c) in den relevanten Arbeitszuständen zu etablieren:
a) der erste Einlaß (6) und der erste Auslaß (7), durch eine Kammer (21) mit innen arbeitendem mechanischem Kühlmittel (13);
b) der zweite Einlaß (9) mit dem ersten Auslaß (7), durch die Kammer (21), auf deren Innenseite das mechanische Kühlmittel (13) nicht arbeitet, und der erste Einlaß (6) mit dem zweiten Auslaß (8);
c) der erste und der zweite Einlaß (6, 9) mit dem ersten Auslaß (7), durch die Kammer (21), bei der inneres mechanisches Kühlmittel (13) arbeitet.

9. Gerät nach Anspruch 7 oder 8, **dadurch gekennzeichnet, daß** die Luftsteuermittel ein Tor (10) enthalten, das von einem Servomotor (11) gedreht werden kann nach der Steuerung der Logikeinheit (12), um eine erste und eine zweite Grenzschalterposition zu erreichen, übereinstimmende Arbeitszustände a) und b), während in Arbeitszustand c) das Tor (10) mehrere Zwischenpositionen einnimmt, wobei jede einzelne einem anderen relativen Anteil von aus den Schränken kommender Luft und von externer Luft in der Mischung entspricht.

10. Gerät nach Anspruch 9, **dadurch gekennzeichnet, daß** die Logikeinheit mit externen Feuchtigkeitsdetektionsmitteln verbunden ist und sich dafür eignet, das Gerät aus dem Arbeitszustand b) oder c) in den Zustand a) zu bringen, wenn die relative Feuchtigkeit einen gegebenen Schwellwert übersteigt.

11. Schrank für Elektronikbaugruppen, einschließlich mehreren Modulen (2A...2C), die die Baugruppen aufnehmen, und mindestens ein zusätzliches Modul (3), das ein Klimaanlagengerät gemäß einem beliebigen der Ansprüche 7 bis 9 aufnimmt.

## Revendications

1. Procédé pour le climatisation thermique d'une armoire contenant des ensembles électroniques, incluant les étapes suivantes :
I. détection de la température de l'air à l'extérieur de l'armoire ;
II. comparaison de la température extérieure avec un seuil de température supérieur et inférieur ;
III. si la température excède le seuil supérieur, fonctionnement en circuit fermé, en envoyant de l'air froid obtenu par refroidissement mécanique, par un moyen de refroidissement mécanique, de l'air chaud aspiré de l'armoire vers les ensembles;
IV. si la température est en-dessous du seuil inférieur, maintien du moyen de refroidissement mécanique désactivé et fonctionnement en circuit ouvert, en envoyant aux ensembles de l'air aspiré de l'environnement externe et en évacuant dans l'atmosphère l'air chaud aspiré de l'armoire;
V. si la température extérieure est dans une plage incluse entre les seuils supérieur et inférieur, envoi d'un flux d'air froid obtenu par refroidissement mécanique d'un mélange incluant à la fois de l'air provenant de l'armoire et de l'air extérieur aux ensembles, dans des proportions dépendant des valeurs de la température extérieure et intérieure.

2. Procédé selon la revendication 1, **caractérisé en ce qu'**il prévoit également les étapes suivantes :
- détection de la température de l'air à l'intérieur de l'armoire ;
- comparaison du résultat de la détection de la température extérieure avec le résultat de celle de la température intérieure ;
- si la comparaison mentionnée ci-dessus fait ressortir que la température intérieure est égale ou supérieure à la température extérieure, redémarrage des étapes du cycle de I.) à V.), tandis que ,
- si la comparaison mentionnée ci-dessus fait ressortir que la température intérieure est en-dessous du seuil inférieur mentionné plus haut, maintien du moyen de refroidissement mécanique désactivé et fonctionnement en circuit fermé, en envoyant de l'air aspiré de l'environnement interne vers les ensembles.

3. Procédé selon la revendication 1, **caractérisé en ce que** ledit seuil de température supérieur est inclus entre 30°C et 50°C, et le seuil de température inférieur est inclus entre 10°C et 25°C.

4. Procédé selon les revendications 1 et 3, **caractérisé en ce que**, dans la plage intermédiaire de température, les proportions relatives d'air provenant des armoires et de l'air extérieur sont modifiées lorsqu'il y a une variation de la température relative incluse entre 2°C et 3°C.

5. Procédé selon une quelconque revendication 1 à 4,
**caractérisé en ce que**, pendant les étapes dans lesquelles de l'air extérieur est envoyé aux ensembles, l'humidité relative de l'air extérieur est surveillée et si elle excède une valeur limite, le fonctionnement est passé en circuit fermé.

6. Procédé selon la revendication 5, **caractérisé en ce que** ladite valeur limite est incluse entre 40% et 80%.

7. Équipement pour le climatisation thermique d'une armoire pour des ensembles électroniques, incluant :
- une première et une deuxième entrée d'air (6, 9), pour faire entrer dans l'équipement de l'air provenant de l'armoire (1) et de l'air extérieur, respectivement ;
- une première et une deuxième sortie d'air (7, 8), pour envoyer de l'air de refroidissement aux ensembles et pour renvoyer de l'air dans l'environnement, respectivement ;
- un moyen de refroidissement mécanique (13) de l'air entré dans l'équipement ;
- une unité de commande logique (12) pour détecter la température de l'air à l'extérieur de l'armoire (1), la comparer avec un seuil de température supérieur et inférieur, activer le moyen de refroidissement mécanique (13) si la température n'est pas inférieure au seuil inférieur, et, sur la base de la température extérieure, commander le fonctionnement de l'équipement selon l'une de trois conditions : a) refroidissement mécanique en circuit fermé, dans lequel l'air provenant de l'armoire (1) est refroidi avec ledit moyen de refroidissement (13) et envoyé aux ensembles si la température excède le seuil supérieur ; b) refroidissement par ventilation libre, dans lequel de l'air aspiré de l'environnement externe est envoyé aux ensembles, à la température ambiante, et l'air aspiré de l'armoire (1) est réintroduit dans l'environnement, si la température extérieure est en-dessous du seuil inférieur ; c) refroidissement mixte, dans lequel un mélange d'air provenant de l'armoire (1) est refroidi avec ledit moyen de refroidissement (13) et mélangé avec de l'air extérieur et envoyé aux ensembles, dans des proportions relatives dépendant de la température extérieure et de la température intérieure, si la température extérieure est dans une plage délimitée par les seuils.

8. Équipement selon la revendication 7, **caractérisé en ce qu'**il inclut un moyen de commande de flux d'air (10), commandé par ladite unité logique (12) et approprié pour établir une communication de a), b) et c) dans les conditions de fonctionnement pertinentes :
a) la première entrée (6) et la première sortie (7), par l'intermédiaire d'une chambre (21) ayant un moyen de refroidissement mécanique (13) fonctionnant à l'intérieur ;
b) la deuxième entrée (9) avec la première sortie (7), par l'intermédiaire de la chambre (21) à l'intérieur de laquelle le moyen de refroidissement mécanique (13) ne fonctionne pas, et la première entrée (6) avec la deuxième sortie (8) ;
c) la première et la deuxième entrée (6, 9) avec la première sortie (7), par l'intermédiaire de la chambre (21) à l'intérieur de laquelle le moyen de refroidissement mécanique (13) fonctionne.

9. Équipement selon la revendication 7 ou 8, **caractérisé en ce que** ledit moyen de commande d'air inclut une porte (10) qui peut être tournée par un servomoteur (11), suite à la commande de l'unité logique (12) afin qu'elle prenne une première et une deuxième position de contact de fin de course, correspondant aux conditions de fonctionnement a) et b), tandis que dans la condition de fonctionnement c), la porte (10) prend une pluralité de positions intermédiaires, chacune correspondant à une proportion relative différente de l'air provenant des armoires et de l'air extérieur dans le mélange.

10. Équipement selon la revendication 9, **caractérisé en ce que** l'unité logique est connectée à un moyen de détection d'humidité extérieure, et appropriée pour faire passer l'équipement de la condition de fonctionnement b) ou c) à la condition a) lorsque l'humidité relative excède un seuil donné.

11. Armoire pour des ensembles électroniques, incluant une pluralité de modules (2A ... 2C) recevant les ensembles, et au moins un module additionnel (3) recevant un équipement de conditionnement d'air selon une quelconque revendication 7 à 9.
